Europäisches Patentamt

European Patent Office

Office européen des brevets

(19)

(11) Numéro de publication : **0 163 554**
**B1**

(12) **FASCICULE DE BREVET EUROPÉEN**

(45) Date de publication du fascicule du brevet :
06.07.88

(51) Int. Cl.⁴ : **G 11 C 27/02, H 04 N 5/217,**
**G 06 G 7/184**

(21) Numéro de dépôt : **85400401.7**

(22) Date de dépôt : **01.03.85**

---

(54) **Accumulateur analogique.**

---

(30) Priorité : **06.03.84 FR 8403435**

(43) Date de publication de la demande :
**04.12.85 Bulletin 85/49**

(45) Mention de la délivrance du brevet :
**06.07.88 Bulletin 88/27**

(84) Etats contractants désignés :
**DE GB**

(56) Documents cités :
**EP-A- 0 017 561**
**EP-A- 0 157 668**
**PROCEEDINGS OF THE 5th INTERNATIONAL CONFE-**
**RENCE ON CHARGE-COUPLED DEVICES, septembre**
**1979, pages 33-39(édité par J. MAVOR, university of**
**Edinburgh); IWASA et al.: "Mosaic CCD Multiplexer**
**for Pyroelectric Hybrid Focal Plane"**
**IEEE Journal of Solid State Circuits, vol. SC-13, no. 1,**
**février 1978, pp. 34-51**

(73) Titulaire : **THOMSON-CSF**
**173, Boulevard Haussmann**
**F-75379 Paris Cédex 08 (FR)**

(72) Inventeur : **Berger, Jean-Luc**
**THOMSON-CSF SCPI 173, bld Haussmann**
**F-75379 Paris Cedex 08 (FR)**
Inventeur : **Brissot, Louis**
**THOMSON-CSF SCPI 173, bld Haussmann**
**F-75379 Paris Cedex 08 (FR)**
Inventeur : **Virando, Bruno**
**THOMSON-CSF SCPI 173, bld Haussmann**
**F-75379 Paris Cedex 08 (FR)**

(74) Mandataire : **Ruellan-Lemonnier, Brigitte et al**
**THOMSON-CSF SCPI 19, avenue de Messine**
**F-75008 Paris (FR)**

EP 0 163 554 B1

Jouve, 18, rue St-Denis, 75001 Paris, France

**0 163 554**

### Description

La présente invention concerne un accumulateur analogique, notamment un accumulateur analogique utilisé en association avec un analyseur d'images à l'état solide pour réaliser le moyennage et la mémorisation du bruit fixe appelé FPN (pour fixed pattern noise en langue anglaise).

En effet, dans les analyseurs d'image à l'état solide, il existe fréquemment une non-uniformité du signal d'obscurité qui se reproduit à chaque ligne. Cette non-uniformité ou bruit fixe est généralement appelée, par l'homme de métier FPN. Pour éliminer cette non-uniformité qui entraîne un défaut sur les images auquel l'œil est très sensible, on la mémorise et on la soustrait à chaque ligne du signal vidéo.

Cette opération est actuellement réalisée à l'aide de circuits numériques de la manière suivante :

Le signal vidéo d'une ou plusieurs lignes noires placées en début de trame, à savoir le signal parasite FPN, est numérisé à l'aide d'un convertisseur analogique-numérique puis stocké dans une mémoire à accès aléatoire. Cette mémoire est ensuite lue à chaque ligne, convertie en analogique à l'aide d'un convertisseur numérique-analogique et le signal FPN parasite est soustrait au signal vidéo pour donner un signal vidéo corrigé sans FPN.

L'inconvénient de cette technique est qu'elle introduit un bruit temporel appelé « bruit en pluie » qui résulte de la mémorisation du bruit temporel lors de l'acquisition du bruit fixe appelé FPN.

En conséquence, divers perfectionnements ont été apportés aux circuits de base afin de réduire l'amplitude du « bruit en pluie ».

Un de ces perfectionnements est décrit, par exemple, dans la demande de brevet européen publiée sous le numéro 89.203 au nom de Sony Corporation et consiste à ajouter un sélecteur de niveau. Toutefois, ces perfectionnements augmentent la complexité donc le coût de fabrication du circuit de base qui comporte déjà un convertisseur analogique-numérique, une mémoire à accès aléatoire et un convertisseur numérique-analogique.

D'autre part, lorsque le signal parasite à soustraire, à savoir le FPN, est constant ou lentement variable au cours des trames, il est connu que le bruit en pluie peut être réduit par accumulation et moyennage de plusieurs lignes de bruit fixe ou FPN. En effet, l'accumulation de plusieurs lignes de FPN permet d'améliorer le rapport FPN/bruit en pluie d'un facteur $\sqrt{M}$, si l'accumulation porte sur M lignes.

On connaît d'autre part, notamment dans l'article IEEE Journal of Solid-State circuits, vol. SC-13, n° 1 Février 1978, pages 34-51, Barbe et al un accumulateur analogique pour intégrer N informations analogiques sur M séquences comprenant un registre à décalage à transfert de charge d'entrée, N moyens de sommation et de stockage et un registre à décalage à transfert de charge de sortie. Toutefois, cette structure est considérée comme spéculative et rien n'est dit dans l'article sur la façon de réaliser les moyens de sommation et de stockage. On connaît aussi d'après le brevet européen EP-A-157 668 publié postérieurement à la date de dépôt de la présente demande, un autre type d'accumulateur analogique.

La présente invention a pour but de remédier aux inconvénients des circuits numériques en proposant un nouvel accumulateur analogique permettant de réaliser l'accumulation de N informations analogiques et leur lecture de façon non destructive.

La présente invention a en conséquence pour objet un accumulateur analogique réalisant M intégrations de N informations analogiques sous la forme de N paquets de charge, l'accumulateur étant du type comportant un registre à décalage à transfert de charge à une entrée série et N sorties parallèles destiné à recevoir les paquets de charge, N moyens de stockage connectés aux N étages du registre par l'intermédiaire de commutateurs permettant le passage des charges des étages du registre aux moyens de stockage, chaque moyen de stockage réalisant pour les M intégrations, la sommation et le stockage temporaire des informations analogiques de rang correspondant, N moyens de lecture connectés aux N moyens de stockage pour lire les informations analogiques contenues dans les moyens de stockage et un registre à décalage à transfert de charge à N entrées parallèles et une sortie série, chaque entrée étant reliée à un des moyens de lecture par l'intermédiaire d'un commutateur permettant le passage périodique des quantités de charge après chaque ensemble de M intégrations, le registre délivrant à la fin des M intégrations l'information accumulée sous forme d'un signal analogique, caractérisé en ce que

— les N moyens de stockage sont constitués par N diodes flottantes de stockage et

— les N moyens de lecture permettent la lecture des informations analogiques contenues dans les moyens de stockage sans les détruire et sont constitués par N diodes flottantes de lecture, chaque diode de lecture étant adjacente à une grille d'injection ($G_1$) connectée à la diode flottante de stockage ($C_{s1}$ à $C_{sN}$) correspondante par une connexion, par des moyens pour injecter dans les diodes flottantes de lecture une charge d'entraînement et par un drain d'évacuation pour éliminer l'excédent de la charge d'entraînement par rapport à la barrière de potentiel réalisé sous la grille d'injection par la connexion.

Les caractéristiques de la présente invention apparaîtront à la lecture de la description d'un mode de réalisation faite avec référence aux dessins ci-annexés dans lesquels :

la figure 1 est une vue en plan de dessus schématique d'un accumulateur analogique conforme à la présente invention ;

les figures 2a à 2d sont respectivement une vue partiellement en perspective et en coupe schématique par II-II de figure 1 et des schémas représentant l'évolution des potentiels de surface en fonction du temps ;

2

les figures 3a et 3b sont respectivement une vue en coupe de la diode flottante d'entrée et de la grille d'injection, un schéma représentant l'évolution des potentiels de surface sous ces éléments lorsque la charge d'entraînement a été injectée et une courbe donnant l'évolution du potentiel de surface en fonction du temps sur la diode flottante ;

la figure 4 est une vue expliquant le procédé utilisé pour réaliser les diodes flottantes de stockage et d'entrée.

Dans les figures les mêmes références désignent les mêmes éléments mais pour des raisons de clarté les cotes et proportions des divers éléments ne sont pas respectées.

D'autre part, la présente invention est décrite en se référant à un accumulateur analogique associé à un analyseur d'images à l'état solide pour l'obtention d'un bruit fixe appelé FPN à faible bruit en pluie. Toutefois, il est évident pour l'homme de l'art que l'accumulateur analogique de la présente invention peut aussi être utilisé à chaque fois qu'il est nécessaire d'avoir une ou des informations analogiques moyennées qui doivent être lues plusieurs fois.

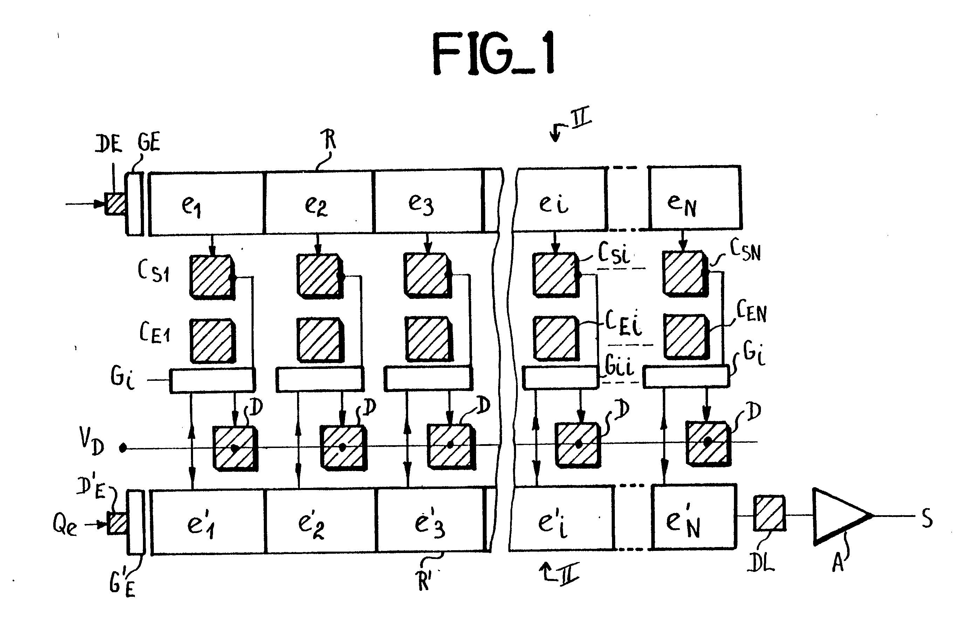

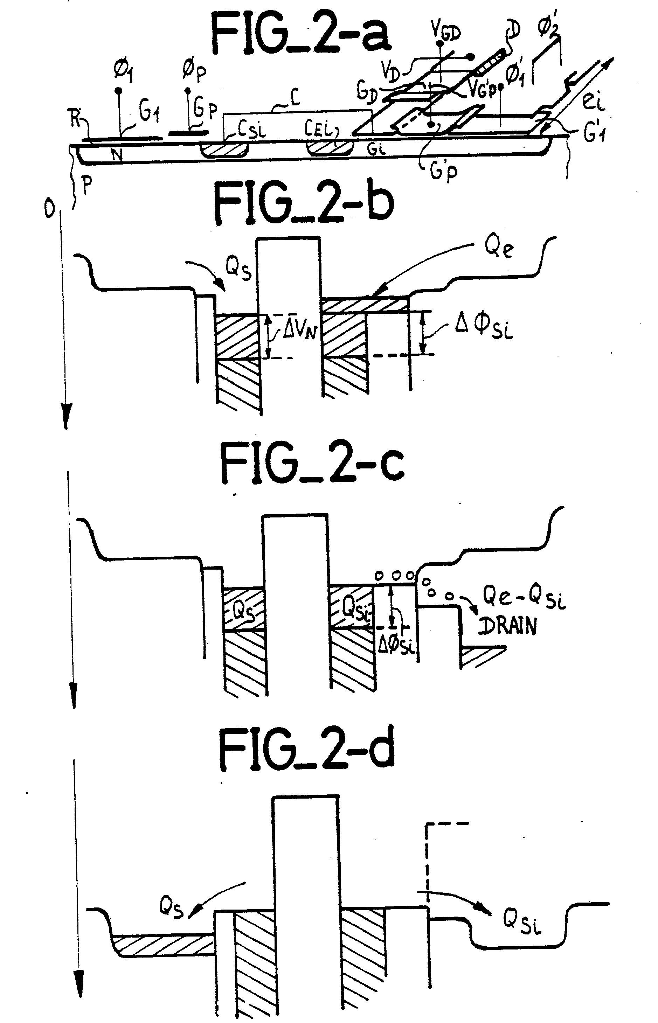

On décrira maintenant avec référence aux figures 1 et 2a, un mode de réalisation préférentiel d'un accumulateur analogique conforme à la présente invention. Cet accumulateur a été réalisé sous forme de circuit intégré en utilisant la technologie CCD (pour charge coupled device) sur un substrat en silicium de type P. De préférence, comme représenté sur la figure 2a, l'accumulateur est réalisé sur une zone N formée dans le substrat en silicium de type P pour avoir un transfert en volume, ce qui limite le bruit de transfert. Toutefois, il est évident pour l'homme de l'art que cet accumulateur peut être réalisé sur d'autres substrats tels qu'un substrat en silicium de type N, en arséniure de gallium ou similaire et que, de plus, le transfert peut être réalisé en surface.

L'accumulateur de la figure 1 comporte tout d'abord un étage de conversion tension-charge représenté symboliquement par la diode $D_e$ et la grille $G_e$ qui transforme les tensions analogiques correspondant au signal FPN en des quantités de charges $Q_{n,m}$. Cet étage de conversion tension-charge est suivi d'un registre à décalage à transfert de charge R de type CCD, à entrée série et sorties parallèles qui, dans le mode de réalisation représenté, fonctionne en bi-phasé. Le registre à décalage à transfert de charge R qui reçoit N quantités de charges correspondant aux N tensions analogiques d'une séquence comporte N étages $e_1$ à $e_N$. Chaque étage du registre est constitué de façon connue, par deux couples d'électrodes comprenant chacun une électrode de transfert et une électrode de stockage. Chaque couple d'électrodes est relié à un potentiel de commande $\phi_1$ et $\phi_2$ alternatif et en opposition de phase. D'autre part, l'électrode de stockage du couple d'électrodes commandé par $\phi_1$ est utilisée comme sortie et elle est référencée $G_1$ sur la figure 2a. L'électrode $G_1$ de chaque étage du registre à décalage R est séparée d'un moyen de stockage des charges par une grille de passage $G_P$ reliée à un potentiel $\phi_P$, comme représenté sur la figure 2a.

Les moyens de stockage et d'accumulation des charges sont constitués par des diodes flottante $C_{S1}$... $C_{Si}$... $C_{Ni}$ réalisées de manière connue par une diffusion de type $N^+$ dans la zone N du substrat.

L'accumulateur analogique de la présente invention comporte de plus des moyens de lecture non destructive des charges qui ont été accumulées dans les diodes $C_{S1}$... $C_{Si}$... $C_{SN}$. Ces moyens de lecture non destructive sont constitués d'une diode flottante d'entrée $C_{E1}$, $C_{E2}$....$C_{Ei}$...$C_{EN}$, d'une grille d'injection des charges $G_i$ adjacente à la diode d'entrée correspondante $C_{E1}$ à $C_{EN}$ et reliée par une connexion C à la diode de stockage correspondante $C_{S1}$ à $C_{SN}$. Cette grille $G_i$ d'injection des charges sépare les diodes d'entrée $C_{E1}$ à $C_{EN}$ d'un drain d'évacuation des charges constitué d'une grille de passage $C_D$ reliée à un potentiel $V_{GD}$ et d'une diode D polarisée par la tension $V_D$ et des étages $e'_1$ à $e'_N$ d'un registre à décalage à transfert de charge R' réalisant le multiplexage des quantités de charge accumulées. D'autre part, les moyens de lecture non destructive comportent un dispositif pour injecter une charge d'entraînement $Q_e$ dont le rôle sera expliqué en détail ci-après. Dans le mode de réalisation de la figure 1, le dispositif d'injection de la charge d'entraînement $Q_e$ est constitué par le registre à décalage à transfert de charge R' qui est muni d'un dispositif d'injection série représenté schématiquement par la diode $D'_e$ et la grille de passage $G'_e$. L'utilisation du registre R' permet d'obtenir une charge d'entraînement $Q_e$ identique au niveau de chaque étage $e'_1$ à $e'_N$ correspondant à chaque moyen de lecture non destructive. D'autre part, le registre à décalage à transfert de charge R' est utilisé pour délivrer en série les N tensions analogiques correspondant aux N quantités de charge accumulées dans les moyens de stockage $C_{S1}$ à $C_{SN}$.

Ce registre à décalage à transfert de charge R' est un registre de type CCD bi-phasé de structure identique au registre à décalage R. Il est commandé par des potentiels de commande $\phi_1$ et $\phi_2$ en opposition de phase dont la fréquence peut être différente de la fréquence des potentiels de commande $\phi_1$ et $\phi_2$ du registre R comme cela sera expliqué ci-après.

D'autre part, l'électrode de stockage du couple d'électrodes commandé par $\phi_1$ est utilisée comme entrée. Elle est référencée $G'_1$ sur la figure 2a et elle est séparée des moyens de lecture par une grille de passage $G'_P$ reliée à un potentiel $\phi_P$.

Le registre à décalage R' est connecté en sortie à un étage de conversion charge-tension représenté symboliquement par la diode $D_L$ et par l'amplificateur A.

On décrira maintenant, en se référant plus particulièrement aux figures 2b à 2d, le fonctionnement de l'accumulateur analogique de la présente invention. Ce fonctionnement est décrit dans le cas où cet accumulateur analogique est associé à un analyseur d'images à l'état solide pour accumuler le signal FPN et obtenir en sortie un signal parasite représentatif du signal FPN avec un bruit en pluie faible.

On réalise tout d'abord l'accumulation dans les moyens de stockage $C_{S1}$ à $C_{SN}$ de plusieurs lignes contenant le signal a soustraire à savoir le signal FPN. Pour réaliser cette opération, à chaque apparition dans le signal vidéo d'une ligne noire contenant le signal à soustraire, le signal vidéo est connecté à l'entrée série du registre à décalage R, à savoir à la diode $D_e$. Le registre à décalage R charge alors tous ses étages $e_1$ à $e_N$ d'une charge $Q_{nm}$ proportionnelle au signal FPN mais entachée de bruit temporel.

Pendant le temps de suppression de lignes, le potentiel $\phi_P$ appliqué sur la grille $G_p$ passe à un niveau haut comme représenté sur la figure 2b et les étages $e_1$ à $e_N$ du registre CCD R sont vidés dans les diodes de stockage $C_{S1}$ à $C_{SN}$.

En recommençant cette opération, on réalise l'accumulation de plusieurs lignes noires dans les moyens de stockage $C_{S1}$ à $C_{SN}$. En fait la durée d'inscription des moyens de stockage $C_{S1}$ à $C_{SN}$ est choisie en fonction de la réduction de bruit souhaitée et dans la limite de la dynamique des moyens de stockage à la température d'utilisation.

D'autre part, la somme des charges arrivant successivement après M séquences d'entrée sur les moyens de stockage $C_{S1}$ à $C_{SN}$ constitués par des diodes flottantes s'accompagne d'une variation de potentiel $\Delta V_N$ à partir d'un potentiel de référence défini ci-après, la valeur de cette variation est donnée par l'équation :

$$\Delta V_N = \frac{Q_S}{C_{Si}} \quad \text{avec} \quad Q_S = \sum_m Q_{n,m}$$

Une fois l'accumulation des charges réalisée, les N moyens de stockage $C_{S1}$ à $C_{SN}$ sont lus de façon non destructive par les moyens de lecture et le registre R' à décalage à transfert de charge à entrées parallèles et sortie série.

Pendant chaque lecture, une charge d'entraînement $Q_e$ uniforme est injectée sur chaque étage du registre R'.

Puis pendant la suppression ligne, on réalise les transferts suivants :

La charge $Q_e$ est alors transférée sur les diodes d'entrée $C_{E1}$ à $C_{EN}$ comme représenté sur la figure 2b.

La charge $Q_e$ est choisie de manière à être supérieure à la charge signal accumulée $Q_S$.

D'autre part, comme les grilles d'injection $G_i$ sont des grilles flottantes connectées par une connexion C aux moyens de stockage $C_{Si}$, la variation du potentiel $\Delta V_N$ est aussi appliquée aux grilles d'injection $G_i$ et il en résulte une variation du potentiel de surface sous chaque grille $G_i$ telle que :

$$\Delta \phi_{Si} = \frac{C_{oxi}}{C_{oxi} + C_{depi}} \cdot \frac{Q_S}{C_{Si}}$$

avec $C_{oxi}$ la capacité d'oxyde sous la grille correspondante et $C_{depi}$ la capacité de dépletion.

De ce fait la charge $Q_e$ supérieure à $Q_S$ se répartit donc dans la diode $C_{Ei}$ et sous la grille $G_i$.

Ensuite, comme représenté sur la figure 2c, on élimine l'excédent de la charge $Q_e$ par rapport à la barrière de potentiel $\Delta \phi_{Si}$. Pour cela on abaisse le potentiel de la grille $G_d$ de sorte que son potentiel de surface soit à un niveau supérieur au potentiel de surface sous la grille $G_i$ pour que les charges en excès soient évacuées vers la diode D.

Il reste alors sur la diode $C_{Ei}$ une charge $Q_{Si}$ telle que :

$$Q_{Si} = C_{Ei} \Delta \phi_{Si} = \frac{C_{oxi}}{C_{oxi} + C_{depi}} \cdot \frac{C_{Ei}}{C_{Si}} Q_S$$

Ensuite, comme représenté sur la figure 2d, la charge $Q_S$ présente sur la diode $C_{Si}$ est renvoyée dans l'étage correspondant $e_i$ du registre à décalage à transfert de charge R en élevant le potentiel $\phi_P$ de la grille $G_P$ lorsque $\phi_1$ est au niveau haut. Ceci provoque sur la grille $G_i$ une variation de potentiel en sens inverse de la variation initiale, c'est-à-dire que la barrière de potentiel $\Delta \phi_{Si}$ disparaît. Le potentiel $\phi_P$ est porté à un niveau haut et la charge $Q_{Si}$ se trouvant dans la diode $C_{Ei}$ se trouve transférée dans l'étage $e'_i$ correspondant du registre à décalage R'.

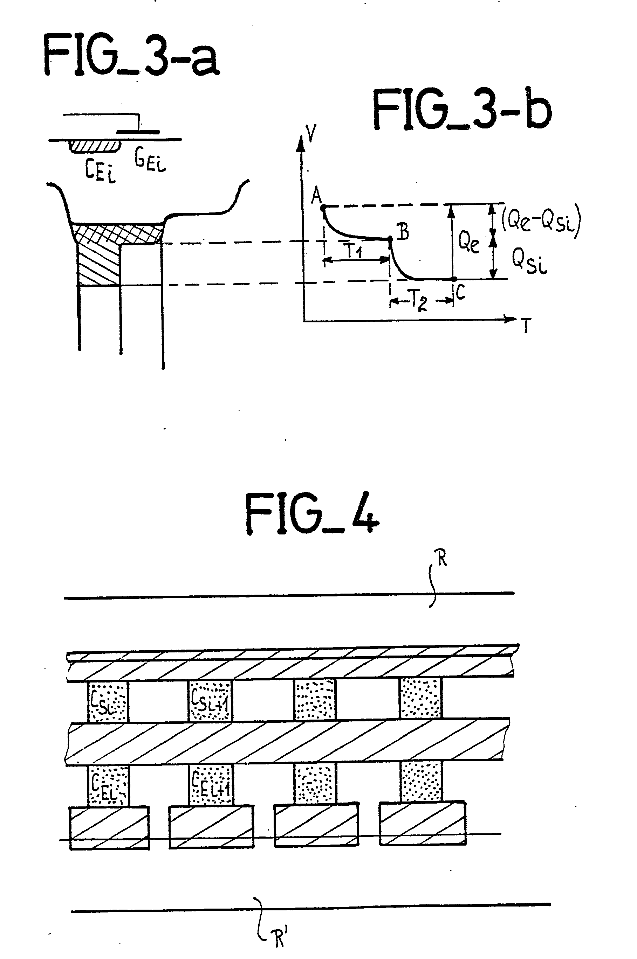

L'évolution du potentiel sur les diodes flottantes en fonction du temps a été représentée sur la figure 3b en se référant à la figure 3a qui correspond à la partie droite de la figure 2b pour voir l'évolution des charges dans la diode.

Ces opérations ayant été réalisées pendant la suppression de ligne on dispose, sur chaque étage $e'_1$ à $e'_N$ du registre à décalage R', de charges $Q_{Si}$ proportionnelles aux charges $Q_S$ qui pourront être lues et soustraites, après ajustement du gain, à chaque ligne vidéo issue d'un analyseur d'images à l'état solide, car l'opération de lecture peut être réalisée pendant chaque suppression de ligne, les charges $Q_S$ accumulées étant stockées dans le registre à décalage R et pouvant être renvoyées sur les moyens de stockage pour une autre lecture.

L'intérêt de l'accumulateur analogique de la présente invention et de la méthode de lecture utilisée avec cet accumulateur est qu'il permet d'obtenir en sortie un signal FPN avec un bruit temporel limité sans rajouter au niveau de chaque conversion des bruits supplémentaires.

En effet, le bruit temporel sur la charge signal $Q_S$ est réduit par les sommations successives. D'autre part, le bruit temporel de lecture des diodes d'entrée $C_{Ei}$ est faible si l'on prend soin d'utiliser des capacités réduites.

De plus, pour éviter d'introduire un FPN multiplicatif qui correspond au gain d'injection lorsque l'on réalise une conversion tension-charge sur un étage, il convient de réduire au maximum les dispersions sur ce gain d'injection.

$$\text{Or } G_i = \frac{C_{oxi}}{C_{oxi} + C_{dipi}} \cdot \frac{C_{Si}}{C_{Ei}}$$

En conséquence, pour réduire les dispersions sur le gain d'injection, on a avantage à utiliser un substrat peu dopé (par exemple un substrat P en silicium dopé à $5.10^{14}$ atomes/cm³ avec une zone N réalisée par une implantation de phosphore sous une dose de $10^{12}$ atomes/cm²) avec une faible épaisseur d'oxyde (par exemple de 500 à 1000 Å) de sorte que :

$$C_{depi} \ll C_{oxi}$$

$$\text{et } \frac{C_{oxi}}{C_{oxi} + C_{Depi}} \# 1$$

Ainsi les dispersions sur cette composante du gain seront très faibles.

D'autre part, il est important de définir les diodes $C_{Si}$ et $C_{Ei}$ par un même niveau de masquage et de façon rigoureusement symétrique comme représenté sur la figure 4 de manière à avoir $C_{Si} = \alpha C_{Ei}$.

En conséquence, si les diodes $C_{Si}$ et $C_{Ei}$ varient d'un étage à l'autre, leur rapport reste constant et on obtient donc $Q_{Si} = \alpha Q_S$.

De plus, l'intérêt de la méthode d'injection parallèle non destructive décrite ci-dessus est de déterminer, étage par étage, la charge injectée par différence entre deux potentiels de surface sous une même grille. La charge injectée ne dépend pas de la valeur absolue de ces potentiels. Elle est donc insensible aux variations de seuil MOS dues aux inhomogénéités spatiales du matériau ou au processus de fabrication.

## Revendications

1. Accumulateur analogique réalisant M intégrations de N informations analogiques sous la forme de N paquets de charge, l'accumulateur étant du type comportant un registre (R) à décalage à transfert de charge à une entrée série et N sorties parallèles destiné à recevoir les paquets de charges, N moyens de stockage ($C_{si}$ à $C_{sn}$) connectés aux N étages du registre (R) par l'intermédiaire de commutateurs ($G_P$) permettant le passage des charges des étages ($e_1$ à $e_N$) du registre (R) aux moyens de stockage, chaque moyen de stockage réalisant pour les M intégrations, la sommation et le stockage temporaire des informations analogiques de rang correspondant, N moyens de lecture ($C_{E1}$ à $C_{EN}$, $G_i$, D) connectés aux N moyens de stockage pour lire les informations analogiques contenues dans les moyens de stockage et un registre (R') à décalage à transfert de charge à N entrées parallèles et une sortie série, chaque entrée étant reliée à un des moyens de lecture par l'intermédiaire d'un commutateur ($G'_P$) permettant le passage périodique des quantités de charge après chaque ensemble de M intégrations, le registre (R') délivrant à la fin des M intégrations l'information accumulée sous forme d'un signal analogique, caractérisé en ce que
— les N moyens de stockage sont constitués par N diodes flottantes de stockage ($C_{s1}$ à $C_{sN}$) et
— les N moyens de la lecture permettent la lecture des informations analogiques contenues dans les moyens de stockage sans les détruire et sont constitués par N diodes flottantes de lecture ($C_{E1}$ à $C_{EN}$), chaque diode de lecture étant adjacente à une grille d'injection ($G_i$) connectée à la diode flottante de stockage ($C_{s1}$ à $C_{sN}$) correspondante par une connexion (C), par des moyens pour injecter dans les diodes flottantes de lecture une charge d'entraînement ($Q_e$) et par un drain d'évacuation (D, $G_D$) pour éliminer l'excédent de la charge d'entraînement Qe par rapport à la barrière de potentiel réalisée sur la grille d'injection ($G_i$) par la connexion (C).

2. Accumulateur analogique selon la revendication 1 caractérisé en ce que le moyen d'injection de la charge d'entraînement est constitué par un dispositif d'injection ($D'_E$ $G'_E$) permettant d'injecter une charge uniforme sur tous les étages ($e'_1$ à $e'_N$) du registre R'.

3. Accumulateur analogique selon l'une quelconque des revendications 1 et 2 caractérisé en ce que la charge d'entraînement ($Q_e$) est supérieure à la charge signal accumulée maximale.

4. Accumulateur analogique selon l'une quelconque des revendications 1 à 3 caractérisé en ce qu'il est réalisé sur une jonction N/P ou une jonction P/N pour avoir un transfert en volume.

# 0 163 554

5. Accumulateur analogique selon l'une quelconque des revendications 1 à 4 caractérisé en ce qu'il est réalisé sur un substrat peu dopé.

6. Accumulateur analogique selon l'une quelconque des revendications 1 à 5 caractérisé en ce qu'il est utilisé en association avec un analyseur d'images à l'état solide comportant au moins une ligne noire par trame pour acquérir la non-uniformité du courant d'obscurité avec un faible bruit temporel afin de réaliser une soustraction de ce signal en sortie de l'analyseur.

## Claims

1. An analog accumulator realising M integrations of N analog informations constituted by N groups of charges, the accumulator being of the type comprising a charge transfer shift register (R) having one series input and N parallel outputs, the register being conceived to receive the groups of charges, the accumulator further comprising N storage means ($C_{si}$ to $C_{sN}$) connected to the N stages of the register (R) via switches ($G_P$) through which the charges of the stages ($e_1$ to $e_N$) of the register (R) are allowed to pass to the storage means, each storage means realising for the M integrations the summing up and the temporary storing of the analog informations of corresponding rank, N reading means ($C_{E1}$ to $C_{EN}$, $G_i$, D) connected to the N storage means in order to read the analog informations contained in the storage means, and a charge transfer shift register (R') having N parallel inputs and one series output, each input being connected to one of the reading means via a switch ($G'_P$) allowing the quantities of charge to pass periodically after each series of M integrations, the register (R') supplying, at the end of the M integrations, the accumulated information in the form of an analog signal, characterized in that
— the N storage means are constituted by N floating storage diodes ($C_{s1}$ to $C_{sN}$) and
— the N reading means are conceived to read in a non-destructive way the analog informations contained in the storage means, and are constituted by N floating read diodes ($C_{E1}$ to $C_{EN}$), each read diode being adjacent to an injection gate ($G_i$) connected to the corresponding floating storage diode ($C_{s1}$ to $C_{sN}$) through a connection (C), that the reading means further comprise means for injecting a driver charge ($Q_e$) into the floating read diodes, and an evacuation drain (D, $G_D$) for eliminating through the connection (C) the excess of driver charge ($Q_e$) with respect to the potential barrier realised on the injection gate ($G_i$).

2. An analog accumulator according to claim 1, characterized in that the driver charge injection means is constituted by an injection device ($D'_E G'_E$) allowing to inject a uniform charge into all the stages ($e'_1$ to $e'_N$) of the register R'.

3. An analog accumulator according to any one of claims 1 and 2, characterized in that the driver charge ($Q_e$) exceeds the maximum accumulated signal charge.

4. An analog accumulator according to any one of claims 1 to 3, characterized in that it is realised on a N/P junction or on a P/N junction in order to provide for a volume transfer.

5. An analog accumulator according to any one fo claims 1 to 4, characterized in that it is realised on a substrate having a low doping rate.

6. An analog accumulator according to any one of claims 1 to 5, characterized in that it is used in association with a solid state picture analyser comprising at least one black line in each frame in order to acquire the non-uniformity of the dark current with a low time noise in order to realise a subtraction of this signal at the output of the analyser.

## Patentansprüche

1. Analoger Akkumulator, der M Integrationen von N analogen Informationen in Form von N Ladungspaketen durchführt, mit einem Ladungstransfer-Schieberegister (R), das einen Reiheneingang und N parallele Ausgänge besitzt und das die Ladungspakete zu empfangen bestimmt ist, mit N Speichermitteln ($C_{si}$ bis $C_{sN}$), die an die N Stufen des Registers (R) über Schalter ($G_P$) angeschlossen sind, über die die Ladungen von den Stufen ($e_1$ bis $e_N$) des Registers (R) an die Speichermittel gelangen können, wobei jedes Speichermittel für die M Integrationen die Summe bildet und die analogen Informationen entsprechenden Stellenwerts vorübergehend speichert, mit N Lesemitteln ($C_{E1}$ bis $C_{EN}$, $G_i$, D) die an die N Speichermittel angeschlossen sind, um die in den Speichermitteln enthaltenen analogen Informationen zu lesen, und mit einem Ladungstransfer-Schieberegister (R'), das N parallele Eingänge und einen Reihenausgang besitzt, wobei jeder Eingang an eines der Lesemittel über einen Schalter ($G'_P$) angeschlossen ist, über den die Ladungsmengen nach jeder Gruppe von M Integrationen periodisch übertragen werden können, wobei das Register (R') am Ende der M Integrationen die akkumulierte Information in Form eines analogen Signals ausgibt, dadurch gekennzeichnet, daß
— die N Speichermittel aus N schwebenden Speicherdioden ($C_{s1}$ bis $C_{sN}$) bestehen, und
— die N Lesemittel das Lesen der in den Speichermitteln enthaltenen analogen Informationen zerstörungsfrei erlauben und aus N schwebenden Lesedioden ($C_{E1}$ bis $C_{EN}$), die je einem Injektionsgate ($G_i$) benachbart sind, das an die entsprechende schwebende Speicherdiode ($C_{s1}$ bis $C_{sN}$) über eine Verbindung (C) angeschlossen ist, aus Mitteln, um in die schwebenden Lesedioden eine Treiberladung

($Q_e$) zu injizieren, und aus einem Drain (D, $G_D$) bestehen, um den Überschuß an Treiberladung ($Q_e$) bezüglich der auf dem Injektionsgate ($G_i$) wirksamen Potentialbarriere über die · Verbindung (C) abzuleiten.

2. Analoger Akkumulator nach Anspruch 1, dadurch gekennzeichnet, daß das Mittel zur Injektion der Treiberladung von einer Injektionsvorrichtung ($D'_E G'_E$) gebildet wird, die es erlaubt, eine gleichförmige Ladung in alle Stufen ($e'_1$ bis $e'_N$) des Registers R' zu injizieren.

3. Analoger Akkumulator anch einem beliebigen der Ansprüche 1 und 2, dadurch gekennzeichnet, daß die Treiberladung ($Q_e$) größer als die maximale akkumulierte Signalladung ist.

4. Analoger Akkumulator nach einem beliebigen der Ansprüche 1 bis 3, dadurch gekennzeichnet, daß er auf einem N/P Übergang oder einem P/N Übergang aufgebaut ist, um einen Volumentransfer zu haben.

5. Analoger Akkumulator nach einem beliebigen der Ansprüche 1 bis 4, dadurch gekennzeichnet, daß er auf einem nur gering dotierten Substrat hergestellt ist.

6. Analoger Akkumulator nach einem beliebigen der Ansprüche 1 bis 5, dadurch gekennzeichnet, daß er in Verbindung mit einem Festkörper-Bildanalysator verwendet wird, der mindestens eine schwarze Zeile pro Rahmen enthält, um die Ungleichförmigkeit des Dunkelstroms mit einem geringen zeitlichen Rauschen zu erzielen, so daß sich eine Subtraktion dieses Signals am Ausgang des Analysators ergibt.

FIG_1

**0 163 554**

FIG_2-a

FIG_2-b

FIG_2-c

FIG_2-d

# FIG_3-a

# FIG_3-b

$C_{Ei}$  $G_{Ei}$

$V$

$A$

$B$

$T_1$

$T_2$  $C$

$(Q_e - Q_{Si})$

$Q_e$

$Q_{Si}$

$T$

# FIG_4

$R$

$C_{Si}$  $C_{Si+1}$

$C_{Ei}$  $C_{Ei+1}$

$R'$